(19)

Europäisches
Patentamt

European
Patent Office

Office européen
des brevets

(11) **EP 4 618 347 A1**

(12) **EUROPEAN PATENT APPLICATION**

(43) Date of publication:
17.09.2025 Bulletin 2025/38

(21) Application number: 24163419.5

(22) Date of filing: 14.03.2024

(51) International Patent Classification (IPC):
*H02J 3/00* (2006.01)  *H02J 13/00* (2006.01)
*G01R 19/25* (2006.01)

(52) Cooperative Patent Classification (CPC):
**H02J 3/0012; G01R 19/2513; H02J 13/00002;**
H02J 2203/20

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Hitachi Energy Ltd**
**8050 Zürich (CH)**

(72) Inventors:
• **KUMAR SAHA, Barun**
**713212 Durgapur, West Bengal (IN)**
• **PARAPURATH, Anoop**
**560067 Bangalore (IN)**

(74) Representative: **Vossius & Partner**
**Patentanwälte Rechtsanwälte mbB**
**Siebertstrasse 3**
**81675 München (DE)**

(54) **METHOD, DEVICE AND COMPUTER-READABLE STORAGE MEDIUM FOR GROUPING DISTURBANCE RECORDS**

(57) The present disclosure relates to a method for grouping disturbance records, DRs, in a power grid. The method comprises obtaining a plurality of DRs, obtaining waveforms of the plurality of DRs, inputting the waveforms into an artificial intelligence, AI, model to extract a plurality of features, and grouping the DRs into at least a first group or a second group based on the extracted features.

```
┌─────────────────────────────────┐
│  S1 Obtaining a plurality of DRs │
└─────────────────────────────────┘
                 │
                 ▼
┌─────────────────────────────────┐
│  S2 Obtaining waveforms of the   │
│         plurality of DRs         │
└─────────────────────────────────┘
                 │
                 ▼
┌─────────────────────────────────┐
│  S3 Inputting the waveforms into an │
│    artificial intelligence, AI, model to │
│      extract a plurality of features │
└─────────────────────────────────┘
                 │
                 ▼
┌─────────────────────────────────┐
│  S4 grouping the DRs into at least a │
│  first group or a second group based │
│       on the extracted features  │
└─────────────────────────────────┘
```

**Fig. 2**

EP 4 618 347 A1

**Description**

The present disclosure relates to a method, device and computer-readable storage medium for grouping disturbance records.

Power grids may consist of a plurality of Intelligent Electronic Devices (IEDs) and similar devices, which generate thousands of disturbance records (DRs). Analysis of DRs can help in gaining insights about the operational aspects of a grid as well as in identification and troubleshooting of problems. A DR is generated when there is a fault in the grid, for example, a short circuit, and shows the behaviour or output(s) of the device for a certain period of time before, during and after the fault. However, DRs are also generated under other scenarios. For example, DRs are generated in response to operational events, such as switching on a reactor. In addition, DRs can be generated solely for the purpose of power quality monitoring and during testing of IEDs. In other words, the latter categories of DRs do not relate to "genuine faults" in a power grid. However, IEEE COMTRADE, the standard used by the DR files, does not have any provision to distinguish between a "real" DR and a "test" DR. Such a segregation is necessary for any meaningful analysis based on the DRs. On the other hand, given the volume of DRs, a manual approach toward such segregation becomes timeconsuming and costly. This is especially useful when collecting all DRs from different regions/stations and bringing them to a centralized location for the analysis. At the station level, some information may be available about test versus real DRs among the people who are working there, but that knowledge may be centrally unavailable. Therefore, there is an acute need to automatically segregate the DRs and identify the subset of DRs among them that potentially relate to genuine faults in a power grid.

This need is met with the features of the present disclosure. In particular, an intelligent and reliable automated or AI-based approach to automatically segregate the DRs into clusters based on the similarity and distortion in the DR waveform images is proposed. Moreover, labels may be assigned to the clusters based on the waveform deviations of the members of the clusters.

The invention is specified by the independent claims. Preferred embodiments are defined in the dependent claims. In the following description, although numerous features may be designated as optional, it is nevertheless acknowledged that all features comprised in the independent claims are not to be read as optional.

The present disclosure relates to a method for grouping disturbance records, DRs, in a power grid. The method comprises obtaining a plurality of DRs, obtaining waveforms of the plurality of DRs, inputting the waveforms into an artificial intelligence, AI, model to extract a plurality of features, and grouping the DRs into at least a first group or a second group based on the extracted features.

Various embodiments may preferably implement the following features.

Preferably, the method further comprises assigning the extracted plurality of features to at least two clusters.

Preferably, the method further comprises determining a standard deviation for each DR and classifying the DRs based on the respective standard deviation.

Preferably, the standard deviations are determined for predetermined time frames, wherein the method further comprises determining a maximum standard deviation for each of the time frames and determining an average of the maximum standard deviation.

Preferably, a cluster having the lowest, second lowest or third lowest average is classified into the second group.

Preferably, a number of clusters is determined based on a clustering efficiency or a metric, preferably a silhouette score.

Preferably, each cluster comprises at least one predetermined time frame.

Preferably, the first group indicates a fault case in the power grid and the second group indicates a normal case or test case in the power grid.

Preferably, the AI model is a convolutional neural network, CNN, or vision transformer.

Preferably, each DR comprises a plurality of channels. Preferably, each DR comprises analogue events, wherein the analogue events are preferably voltage and/or current measurements. Preferably, each DR comprises binary events, wherein the binary events are preferably switching states of a device connected to the power grid. Preferably, the device is an Intelligent Electronic Device, IED, and the binary events are internal signals of power system functions.

Preferably, obtaining of a DR of the plurality of DRs is triggered by a fault signal.

Preferably, the DR comprises voltage and/or current levels and/or at least one configuration parameter of an electronic equipment of the power grid before the fault signal.

Preferably, the method further comprises estimating a fault location based on the DR and at least one additional parameter.

Preferably, the additional parameter is a transmission network map of the power grid and/or domain knowledge of the power grid and/or historic data of the power equipment of the power grid.

Preferably, obtaining a plurality of DRs comprises obtaining historical DRs and/or stored DRs. Preferably, the method further comprises determining a type of fault based on the obtained plurality of DRs. Preferably, the method comprises determining a frequency of occurrence of the type of fault.

Preferably, each DR of the plurality of DRs has a predetermined length.

Preferably, the extracted features are compressed and/or normalised.

Preferably, the plurality of DRs comprise a trigger channel name and/or a description of the trigger and/or related embeddings.

The present disclosure further relates to a computer-readable storage medium which, when read by a processor, instruct the processor to perform the method as described above.

The present disclosure further relates to a device connected to a power grid comprising a processor configured to perform the method as described above.

Other aspects, features, and advantages will be apparent from the summary above, as well as from the description that follows, including the figures and the claims.

Embodiments of the present disclosure will now be described by way of example only and with reference to the following accompanying drawings. In the figures, the same reference numerals denote the same or similar elements.

   Fig. 1 shows a real DR and a test DR according to an embodiment.
   Fig. 2 shows a flow chart of a method according to an embodiment.
   Fig. 3 shows a flow chart of a method according to an embodiment.

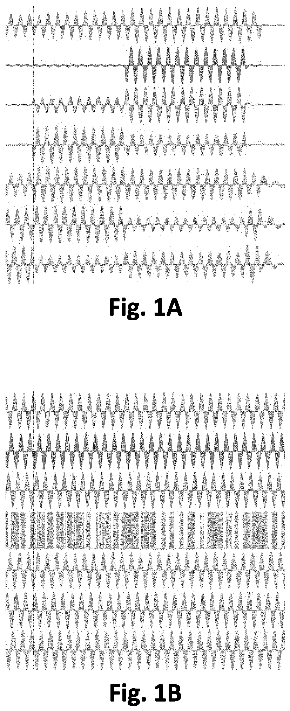

Figs. 1A and 1B show exemplary disturbance records (DRs) for further describing the present disclosure. Both DRs comprise seven channels (y-axis) depicted over time (x-axis). The channels may show the behaviour of different parameters of a device or a power grid over time. For example, the channels may relate to current and voltage, respectively, of a threephase system and the neutral line.

As can be seen in Fig. 1A, the graphs of all channels exhibit significant visible waveform distortions that deviate from the expected, substantially sinusoidal waveforms. This DR may be classified as a "real" DR showing an actual disturbance in the power grid.

Fig. 1B on the other hand shows substantially regular sinusoidal waveforms in the first to third and fifth to seventh channel and irregular waveforms in the fourth channel. This DR may be classified as a "test" DR not indicative of an actual fault. As outlined above, a "test" DR may be generated, e.g., due to manual switching of a reactor, test performance, power quality monitoring or the like.

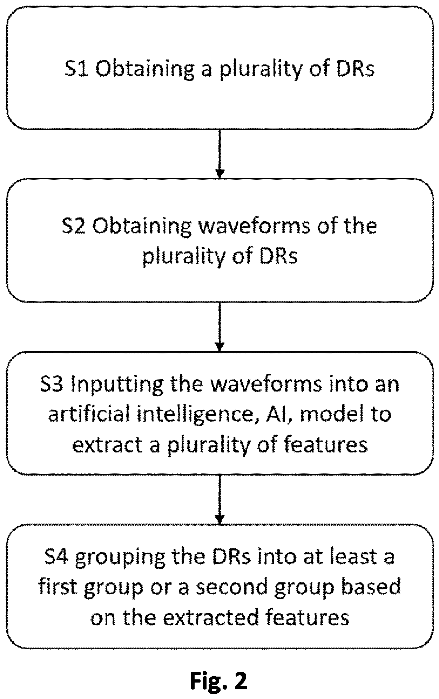

Fig. 2 shows a flow chart of a method for grouping the DRs according to an embodiment. In particular, the proposed method comprises obtaining (S1) a plurality of DRs, obtaining (S2) waveforms of the plurality of DRs, inputting (S3) the waveforms into an artificial intelligence, AI, model to extract a plurality of features, and grouping (S4) the DRs into at least a first group or a second group based on the extracted features.

The first group may indicate a fault case in the power grid and the second group may indicate a normal case or test case in the power grid. However, the DRs may also be classified into more than two groups.

In an embodiment, the method further comprises assigning the extracted plurality of features to at least two clusters. This will be further described below.

Moreover, a standard deviation for each DR may be determined for classifying the DRs based on the respective standard deviation. The standard deviations may be determined for predetermined time frames. In particular, a maximum standard deviation for each of the time frames may be determined. Subsequently, an average of the maximum standard deviation may be determined.

A cluster having a low average, e.g., the lowest, second lowest or third lowest average, may be classified into the second group. A number of clusters may be determined based on a clustering efficiency or a metric, preferably a silhouette score. Each cluster may comprise at least one predetermined time frame.

The AI model may be a convolutional neural network, CNN, or vision transformer. However, other AI models may also be employed.

As outlined above, each DR may comprise a plurality of channels. Each DR may comprise analogue events, and the analogue events may be voltage and/or current measurements. However, the channels and events are not limited to voltage and current measurements and depending on the device generating the DRs, other parameters may be comprised in the DRs.

Each DR may comprise binary events, wherein the binary events may be switching states of a device connected to the power grid and/or internal binary states of the device such as a start or trip signal. The device may be an Intelligent Electronic Device, IED. The binary events may be internal signals of power system functions. Further to various states of the devices connected to the power grid, the signal(s) can be the output of functions monitoring current and voltage of the power system. 'Start', e.g., may indicate that the current crossed a certain threshold/limit. 'Trip', e.g., may indicate the next step after the 'Start'. I.e., when, after the current crossed the limit, no action is taken, a next action needs to be taken. Towards this 'Trip' output from the function running inside the IED will be activated. Both 'Start' and 'Trip' may be captured in the DR. 'Trip' may initiate opening of a circuit breaker to isolate the fault.

Obtaining of a DR of the plurality of DRs may be triggered by a fault signal. The fault signal may be generated by a device connected to the power grid, e.g., an IED or power equipment.

The DR may comprise voltage and/or current levels and/or at least one configuration parameter of an electronic equipment of the power grid before the fault signal. That is, data may be buffered, e.g., in a first-in-first-out (FIFO) buffer, for a certain period of time and the trigger signal/fault signal prompts the device to store the data before, during and after the fault signal. The length may be predetermined.

In that manner, the behaviour around the time of the fault may be examined. The recording intervals (i.e., the predetermined length) may be configured in the disturbance recorders (e.g., the IEDs). The fault trigger time and the recording start time may be available in the DR configuration files. E.g., the configuration files may follow IEEE COMTRADE. As an example, a recording can contain data starting from 100 milliseconds, preferably 60 milliseconds, more preferably 30 milliseconds or less, before the fault was detected and can extend up to 500 milliseconds, preferably 320 milliseconds, more preferably 250 milliseconds or less after the fault detection time.

Moreover, a fault location may be determined based on the DR and at least one additional parameter. The additional parameter may be, e.g., a transmission network map of the power grid and/or domain knowledge of the power grid and/or historic data of the power equipment of the power grid.

Also, the plurality of DRs may comprise historical DRs and/or stored DRs. A type of fault may be determined based on the obtained plurality of DRs. That is, the type of fault may be determined using historic and/or actual/recent data.

Further, a frequency of occurrence of a particular type of fault may be determined.

The above analysis or determination of a fault location may be based on at least one of the first or second group and may disregard other groups. In particular, it may be based on at least one group pertaining to actual fault cases, e.g., the first group.

Each DR of the plurality of DRs may have a predetermined length. The extracted features may be compressed and/or normalised for processing. For the predetermined length, the above equally applies.

The plurality of DRs may further comprise a trigger channel name and/or a description of the trigger and/or related embeddings.

An embodiment of the disclosure further relates to a computer-readable storage medium comprising instructions which, when read by a processor, instruct the processor to perform the method as described above.

An embodiment of the present disclosure further relates to a device connected to a power grid comprising at least one processor configured to perform the method as described above. The device may further comprise a memory and/or a wired or wireless communication unit.

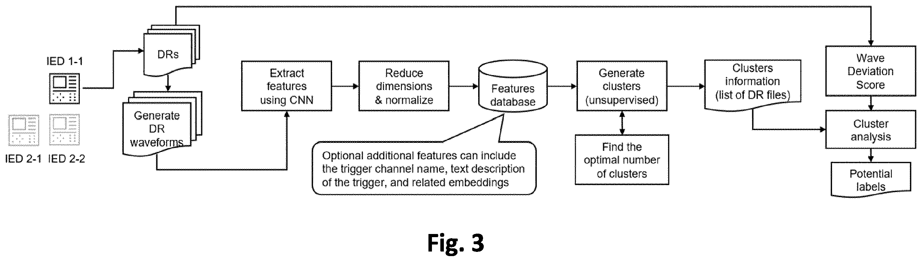

Fig. 3 is a further flow chart of a method according to an embodiment. According to the flow chart, DRs from one or more IEDs 1-1, 2-1, 2-2 are obtained and DR waveforms are generated. The DRs collected from each IED may be processed separately using the pipeline demonstrated in Figure 3. For example, the DRs from IED 1-1 are processed together. The DRs from IED 2-1 are processed separately, and so on. During each batch of processing the DRs for each IED, a wave deviation score (WDS) is determined for subsequently grouping the DRs/clusters to real or test DRs (disturbance/no disturbance). The WDS may be computed by considering the average of the maximum standard deviation of the sample values for each analogue channel of a subset of DRs from a given cluster.

From the waveforms, features are extracted, e.g., using an artificial intelligence such as CNN or vision transformer. After dimension reduction (compression) and normalisation, the features are stored in a feature database. Additional features may include at least one of the trigger channel name, text description of the trigger, or related embeddings. Using the data from the feature database, clusters are generated in an unsupervised manner. The optimal number of clusters is automatically determined. Using the cluster information and the wave deviation score, the clusters are analysed, and labels are assigned to the clusters.

The disclosure will now be described in more detail. Referring again to Fig. 1A, the DRs generated in a power grid can be created because of a genuine fault in the grid. They may also be referred to as "real DRs" or "disturbance". In addition, DRs can be created due to several other reasons, such as the manual operational event of switching a reactor on, a passive power quality monitoring function based on the waveforms, and potential testing of the grid or disturbance recorders. Fig. 1B shows the waveforms of such a DR from the same IED. They may also be referred to as "test DRs" or "no disturbance". Embodiments of the present disclosure are capable of segregating the two types of DRs - "real" and "test" - shown in the two figures.

The configuration file of a DR specifies the different analogue and digital channels used, among others. The data file of a DR contains the sampled values for each channel. Let there be $n > 0$ samples recorded in a DR data file for each channel. Let $t > 0$ be the trigger index. Let w3 be an integer index such that $t < w3 <= n$. For example, if $n = 100$ and only the subset of the first 60 sample values from the beginning are to be considered, then w3 is set to 60. Thus, w3 contiguous samples from the beginning for each analogue channel are considered and the waveforms are plotted, as shown in Fig. 1A. A vertical line is also drawn at index t to indicate the trigger time. This process is repeated to generate the waveform images for all the DR files collected from a given IED.

A deep neural network is used to extract features from the waveform images. For example, a Convolutional Neural Network (CNN) can be used for this purpose. Several state-of-the-art CNN architectures are known in the literature, such as EfficientNetV2M. Any such pre-trained model can be used. Alternatively, a vision transformer (ViT) can also be used.

A pre-trained CNN is used to extract features from the waveform images. In particular, an image is fed to the CNN and the output of the penultimate layer is considered. Subsequently, Principal Component Analysis (PCA) is performed in order to reduce the dimension of the feature vector. Finally, the dimensionality-reduced feature vector is normalised. The process is repeated for all the DRs collected from a given IED. These features are stored in a database for future use.

The features extracted from the DR waveforms are segregated into k clusters, where the minimum value of k is 2. The maximum value of k may be another small integer, for example, 6. Any suitable clustering technique, for example, k-means clustering, can be used for this purpose. An optimum number of clusters is determined based on the clustering efficiency. The efficiency can be computed using an appropriate metric, for example, Silhouette score.

The optimum value of k is the one that results in the maximum value of clustering efficiency and is referred to as k*.

In many cases, the value of k* would be 2, which completes the clustering step since a binary segregation of the DRs have been achieved. However, in some cases, the value of k* would be greater than 2. In such scenarios, the next step is applied.

Let w1 and w2 be two integers such that $0 <= w1 < t < w2 <= w3 <= n$. The contiguous sample values inside the window [w1, w2] around the trigger index t for each analogue channel for a given DR are considered. Let $\sigma_{i,j}$ be the standard deviation (SD) of the ith analog channel for the jth DR belonging to a cluster. Then, $\max_i \sigma_{i,j}$ is the maximum SD observed for a given DR and a given window. Moreover, let

$$\varsigma = \left(\frac{1}{m}\right) \sum_{j=1}^{m} \max_i \sigma_{i,j}$$

be the average of the maximum SDs for a set of m DRs randomly sampled from a given cluster, hereafter referred to as the Wave Deviation Score (WDS) of the cluster.

The cluster with the index

$$argmin_{2 \leq i < k*} \varsigma_i$$

, i.e., the cluster with minimum WDS, is labelled with "No disturbance." The other clusters are labelled with "Disturbance."

The DRs segregation algorithm generates structured output, for example, in JSON format, containing information about the two clusters. The clusters are identified using an appropriate identifier, for example, "0" and "1." In addition, the label ("Disturbance" or "No disturbance") for each cluster identifier is also captured. Each cluster contains a list of the DR file names (based on which the waveform images were generated). The detailed information is stored in a database for any potential future analysis.

The segregation of DRs into clusters is performed with data (DRs) that are currently available. When new DRs become available in the future, their cluster membership needs to be determined. The following steps describe a cluster assignment process for unseen DRs according to an embodiment:

1. For any unseen DR, let x be the feature vector extracted from its waveform image.

2. Let $y_{i,j}$ be the feature vector of the jth DR belonging to cluster i, where i is the index of one the pre-existing clusters.

3. Let $sim(x,y_{i,j})$ be the similarity between the two vectors. Any appropriate metric, such as cosine similarity, can be used for this purpose.

4. The average similarity that x has with the members of cluster i is computed by as:

$$S(x, i) = \sum_{j=1}^{m} sim\left(x, y_{i,j}\right)$$

, where m > 0 samples are randomly selected from the cluster.

5. The DR x is assigned to the cluster having the index $argmax_i\ S(x, i)$.

6. In addition, the system may be instructed to regenerate the clusters from scratch at any point of time using an external (human-induced or automatically detected) input/configuration/trigger.

That is, using the previously gathered data and grouping, new DRs may be grouped using a similarity between the new DRs and already classified DRs.

Alternatively, the cluster label assignment for individual DRs may be deferred until a threshold volume of new DRs for the concerned IED has been accumulated. At that point, the entire process of DRs segregation and clusters generation may be executed afresh.

Additionally or optionally, the DR files segregation process may include one or more of the following steps to further fine-tune the segregation between real and test DRs:

Rather than extracting the features from images, it might be possible to use the sample values from DR data files. For example, if there are seven analogue channels and ten samples per channel are to be considered, then a feature vector of length 7 * 10 = 70 is achieved. Alternatively, appropriate aggregation operators, such as addition and average, may be used to combine them so that the feature vector is only 10 elements long. Since the sample values are directly used as features, they can be normalised and clustered. In other words, this alternative approach of feature generation does not require a neural network.

Bay-level maintenance schedule available in other information systems: It may be assumed that the maintenance windows are known, for example, 5 PM to 6 PM on certain days. All DR files created during such windows are regarded as "test DRs." This can be considered as a post-processing step to obtain further clarity on the clusters of DRs already formed. Alternatively, this can be considered as a pre-processing step to mark the concerned DRs as test data and exclude such DRs from the aforementioned steps.

Manually assigned labels: For a subset of the DRs, manually assigned labels indicating "real DR" or "test DR" (alternatively, "Disturbance" or "No disturbance") may be available. Such labels can be used to approximate which cluster contains what kind of DRs. For example, if a cluster has relatively higher percentage of DRs that are manually labelled as "Disturbance," then the cluster largely contains "real DRs". On the other hand, if a cluster has relatively higher percentage of DRs that are manually labelled as "No disturbance," then the cluster largely contains "test DRs."

Alternative method of clustering: In an alternative scenario, the segregation begins with a subset of the DRs having manually assigned (binary) labels. The maintenance schedule-based automatic labelling with "No disturbance," as discussed earlier, may also be used here. The two initial clusters are formed by putting all the DRs with the same label in the same cluster. Subsequently, the appropriate cluster for the unlabelled DRs are determined. In particular, for each unlabelled DR, its average similarity to each of the two clusters (by taking a random sample of the cluster members) is computed. The unlabelled DR is then assigned to the cluster with which it has the highest average similarity.

According to the present disclosure, the DRs that should be used for any kind of analysis can be reliably identified. Clustering is an unsupervised learning technique, so it requires no input (or effort) from the users. The clusters are formed based on the DRs of a given IED. Therefore, the mechanism is general enough to capture the differences that may arise in the DRs of different IEDs.

The present disclosure thus provides a reliable and efficient method for grouping disturbance records in a power grid allowing for purposeful analysis of the DRs for fault determination, fault location, operational data and the like. Moreover, the present disclosure provides automatic segregation of DRs collected from substation devices, such as IEDs, into at least two categories/groups based on the features extracted, reduced, and normalised from the DR waveform images as well as the labelling of clusters based on their composition.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any one of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any one of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any one of the various illustrative logical blocks, units, processors, means, circuits, methods and functions described in connection with the aspects disclosed herein can be implemented by electronic hardware (e.g., a digital implementation, an analogue implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

In this document, the term "unit" as used herein, refers to software, firmware, hardware, and any combination of these elements for performing the associated functions described herein. Additionally, for purpose of discussion, the various units are described as discrete units; however, as would be apparent to one of ordinary skill in the art, two or more units may be combined to form a single unit that performs the associated functions according embodiments of the present disclosure.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

**Claims**

1. Method for grouping disturbance records, DRs, in a power grid, the method comprising:

   obtaining (S1) a plurality of DRs,
   obtaining (S2) waveforms of the plurality of DRs,
   inputting (S3) the waveforms into an artificial intelligence, AI, model to extract a plurality of features, and
   grouping (S4) the DRs into at least a first group or a second group based on the extracted features.

2. Method according to claim 1, wherein the method further comprises assigning the extracted plurality of features to at least two clusters.

3. Method according to claim 1 or 2, wherein the method further comprises determining a standard deviation for each DR and classifying the DRs based on the respective standard deviation.

4. Method according to claim 3, wherein the standard deviations are determined for predetermined time frames, wherein the method further comprises determining a maximum standard deviation for each of the time frames and determining an average of the maximum standard deviation,
   wherein a cluster having the lowest, second lowest or third lowest average is classified into the second group.

5. Method according to any one of claims 2 to 4, wherein a number of clusters is determined based on a clustering efficiency or a metric, preferably a silhouette score.

6. Method according to claim 4 or 5, wherein each cluster comprises at least one predetermined time frame.

7. Method according to any one of claims 1 to 6, wherein the first group indicates a fault case in the power grid and the second group indicates a normal case or test case in the power grid.

8. Method according to any one of claims 1 to 7, wherein the AI model is a convolutional neural network, CNN, or vision transformer.

9. Method according to any one of claims 1 to 8, wherein each DR comprises a plurality of channels, and/or,

wherein each DR comprises analogue events, wherein the analogue events are preferably voltage and/or current measurements, and/or wherein each DR comprises binary events, wherein the binary events are preferably switching states of a device connected to the power grid, wherein preferably, the device is an Intelligent Electronic Device, IED, and the binary events are internal signals of power system functions.

10. Method according to any one of claims 1 to 9, wherein obtaining of a DR of the plurality of DRs is triggered by a fault signal, wherein preferably, the DR comprises voltage and/or current levels and/or at least one configuration parameter of an electronic equipment of the power grid before the fault signal.

11. Method according to claim 10, wherein the method further comprises estimating a fault location based on the DR and at least one additional parameter, wherein the additional parameter is a transmission network map of the power grid and/or domain knowledge of the power grid and/or historic data of the power equipment of the power grid.

12. Method according to any one of claims 1 to 11, wherein obtaining a plurality of DRs comprises obtaining historical DRs and/or stored DRs,

wherein the method further comprises determining a type of fault based on the obtained plurality of DRs, and wherein the method preferably comprises determining a frequency of occurrence of the type of fault.

13. Method according to any one of claims 1 to 13, wherein each DR of the plurality of DRs has a predetermined length, and/or

wherein the extracted features are compressed and/or normalised, and/or

wherein the plurality of DRs comprise a trigger channel name and/or a description of the trigger and/or related embeddings.

14. Computer-readable storage medium which, when read by a processor, instruct the processor to perform the method according to any one of claims 1 to 13.

15. Device connected to a power grid comprising a processor configured to perform the method according to any one of claims 1 to 13.

Fig. 1A

Fig. 1B

S1 Obtaining a plurality of DRs

S2 Obtaining waveforms of the plurality of DRs

S3 Inputting the waveforms into an artificial intelligence, AI, model to extract a plurality of features

S4 grouping the DRs into at least a first group or a second group based on the extracted features

**Fig. 2**

**Fig. 3**

Europäisches
Patentamt

European
Patent Office

Office européen
des brevets

# EUROPEAN SEARCH REPORT

**Application Number**

EP 24 16 3419

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NEGNEVITSKY M ET AL: "A neuro-fuzzy system for recognition of power quality disturbances", POWER ENGINEERING SOCIETY GENERAL MEETING, 2005. IEEE SAN FRANCISCO, CA, USA JUNE 12-16, 2005, PISCATAWAY, NJ, USA,IEEE, 12 June 2005 (2005-06-12), pages 1434-1439, XP010821619, DOI: 10.1109/PES.2005.1489374 ISBN: 978-0-7803-9157-4 | 1-7, 13-15 | INV. H02J3/00 H02J13/00 G01R19/25 |
| Y | * abstract * * page 1 - page 2 * * page 4 * | 8-12 | |
| Y | US 2020/292608 A1 (YAN WEIZHONG [US] ET AL) 17 September 2020 (2020-09-17) * paragraphs [0022], [0053], [0062], [0070], [0071], [0100] - [0104] * | 8-12 | |

TECHNICAL FIELDS
SEARCHED      (IPC)

H02J
G01R

The present search report has been drawn up for all claims

| Place of search | Date of completion of the search | Examiner |
|---|---|---|
| Munich | 7 August 2024 | Zettler, Karl-Rudolf |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 16 3419

This annex lists the patent family members relating to the patent documents cited in the above-mentioned European search report.
The members are as contained in the European Patent Office EDP file on
The European Patent Office is in no way liable for these particulars which are merely given for the purpose of information.

07-08-2024

| Patent document cited in search report | Publication date | Patent family member(s) | | Publication date |
|---|---|---|---|---|
| US 2020292608 A1 | 17-09-2020 | US | 2020292608 A1 | 17-09-2020 |
| | | US | 2020293032 A1 | 17-09-2020 |
| | | US | 2020293033 A1 | 17-09-2020 |

EPO FORM P0459

For more details about this annex : see Official Journal of the European Patent Office, No. 12/82